# EUROPÄISCHE PATENTANMELDUNG

(11) **EP 2 042 838 A1**
(43) Veröffentlichungstag der Anmeldung: **01.04.2009**
(21) Anmeldenummer: 07117119.3
(22) Anmeldetag: 25.09.2007
(51) Int. Cl.: G01D 5/246, G01G 21/28

(54) **Verfahren zur Messwerterfassung in einer Mehrfach-Kraftmessvorrichtung, Mehrfach-Kraftmessvorrichtung und Kraftmessmodul**

(71) Anmelder: Mettler-Toledo AG, 8606 Greifensee (CH)
(72) Erfinder: Uster, Markus, 8606, Nänikon (CH); Reber, Daniel, 8322, Madetswil (CH); Bucher, Cyrill, 8610, Uster (CH)

(57) **Zusammenfassung**

Die Erfindung betrifft ein Verfahren und den dazu geeigneten Vorrichtungen zur Messwerterfassung einer Mehrfach-Kraftmessvorrichtung, insbesondere einer Mehrfach-Wägevorrichtung, mit mindestens zwei, jeweils mindestens eine Kraftmesszelle aufweisende Kraftmessmodulen und mit mindestens einer Signalleitung mittels der die von den Kraftmesszellen erzeugten Messsignale an eine Auswerteeinheit übertragen werden. Dabei wird in den jeweiligen Kraftmessmodulen das Messsignal zu einem pulsförmigen Sendesignal moduliert und dieses Sendesignal über die mindestens eine Signalleitung an die Auswerteeinheit übertragen.

## Beschreibung

Die vorliegende Erfindung betrifft ein Verfahren zur Messwerterfassung in einer Mehrfach-Kraftmessvorrichtung, insbesondere in einer Mehrfach-Wägevorrichtung, eine Mehrfach-Kraftmessvorrichtung und ein dazu geeignetes Kraftmessmodul.

Unter einer Mehrfach-Kraftmessvorrichtung ist eine modular aufgebaute Kraftmessvorrichtung zu verstehen, bei der mindestens zwei unabhängig zu messende Kräfte mit mindesten zwei unabhängigen Kraftmessmodulen individuell erfasst werden. Eine besondere Form der Mehrfach-Kraftmessvorrichtung ist eine Mehrfach-Wägevorrichtung, bei der die unabhängig zu messenden Kräfte durch die Gewichtskraft von mindestens zwei unabhängigen Wägegütern, den sogenannten Lasten, gebildet werden. Die Kraftmessmodule werden in diesem Fall als Wägemodule bezeichnet.

Die Kraftmessmodule weisen zur Bestimmung der einwirkenden Kraft jeweils eine mechanisch-elektrische Kraftmesszelle auf, die als Messgrössenumformer wirkt indem sie die Eingangsgrösse Kraft in ein korrespondierendes, elektrisches Messsignal umformt. In entsprechender Weise erfolgt die Messgrössenumformung bei einem Wägemodul durch eine sogenannte Wägezelle, welche ein elektrisches Messsignal erzeugt, das zu der vom Wägegut ausgeübten Gewichtskraft korrespondiert.

Die Messsignale der einzelnen Kraftmessmodule beziehungsweise der einzelnen Wägemodule werden im Allgemeinen an eine Auswerteeinheit zur Auswertung weitergeleitet. Dabei ist die Auswerteeinheit oft als zentrale Verarbeitungseinheit ausgebildet, mit der die aus den Messsignalen gewonnenen Messergebnisse beispielsweise zur Anzeige gebracht, an einem Leitrechner übermittelt oder einer Anlagensteuerung zugeführt werden können.

Mehrfach-Wägevorrichtungen finden typischerweise ihren Einsatz in automatisierten Produktions- und Testanlagen zum Verwiegen gleichgearteter Wägegüter. Insbesondere gehören dazu Anlagen für die Produktion und/oder Überprüfung von kleinen, relativ teuren Teilen, beispielsweise in Abfüll- und Verpackungsmaschinen für Tabletten, Kapseln oder Ampullen in der Pharmaindustrie, oder bei der Kontrolle von Kugellagern in der Maschinenindustrie. Beim Wiegen gleichgearteter Wägegüter handelt es sich um einen Vorgang, bei dem mehrere Lasten individuell zu wiegen sind, beispielsweise zum Zwecke des Kontrollierens, des Dosierens oder des Abfüllens auf engem Raum.

Die Anforderungen an eine solche Mehrfach-Kraftmessvorrichtung bestehen darin, dass die Kraftmessmodule eine hohe Messgenauigkeit, eine hohe Reproduzierbarkeit und somit eine hohe Stabilität aufweisen, möglichst platzsparend und kompakt angeordnet werden können und dass die einzelnen Kraftmessmodule möglichst einfach und kostengünstig aufgebaut sind.

In der US6112162 wird eine Mehrfach-Wägevorrichtungen beschrieben, bei der die analogen Signale der einzelnen Wägezellen einer zentralen Schaltvorrichtung, einem sogenannten Multiplexer, zugeführt werden. Somit kann sowohl der Verstärker als auch der Analog-Digital-Wandler von den einzelnen Kraftmessmodulen, jeweils während gewissen Zeitintervallen genutzt werden. Allerdings werden dabei die störungsempfindlichen Messsignale der Wägezellen über Verbindungsleitungen zur zentralen Auswerteeinheit und dort über die Schaltvorrichtung geführt. Dadurch können störende Einflüsse, welche sich aus der Übertragung der Signale ergeben oder welche durch die Schaltvorrichtung entstehen, die Qualität der Messsignale verschlechtern. Dementsprechend ist die erreichbare Messgenauigkeit beschränkt und die beschriebene Vorrichtung für den Einsatz mit hohen Genauigkeitsanforderungen weniger geeignet.

Des Weiteren offenbart die DE 10 2005 025 534 B3 eine Anordnung, bei der die für den Betrieb des Wägemoduls notwendige Elektronik direkt unterhalb der Wägezelle, im unteren Teil des Wägemoduls angeordnet ist. Dadurch können die aus der Übertragung des Messsignals resultierenden Störungen vermieden werden. Nachteilig bei dieser Anordnung sind jedoch sowohl die hohen Kosten, welche aus dem grossen Platzbedarf und dem hohen Vervielfältigungsgrad der Elektronik resultieren als auch die Störungen der Wägezellen, welche sich aus der Wärmeentwicklung der Elektronikbauteile ergeben. Die Problematik der Wärmeentwicklung besteht darin, dass die von der Elektronik erzeugte Wärme gemäss dem bekannten Phänomen des Auftriebs zu den wärmeempfindlichen Wägezellen aufsteigt und somit die Genauigkeit und/oder die Stabilität der Messvorrichtung beeinträchtigen kann.

Der vorliegenden Erfindung liegt daher die Aufgabe zugrunde, ein Verfahren zur Messwerterfassung einer Mehrfach-Kraftmessvorrichtung, insbesondere einer Mehrfach-Wägevorrichtung, eine Mehrfach-Kraftmessvorrichtung und eine geeignetes Kraftmessmodul anzugeben, mit welchen ein einfacher, kostengünstiger, hohen Anforderungen bezüglich Messgenauigkeit und Stabilität erfüllender Aufbau und Betrieb der Messvorrichtung erreicht welche kann.

Diese Aufgabe wird mit einem Verfahren, einer Mehrfach-Kraftmessvorrichtung und einem Kraftmessmodul gelöst, welche die in den unabhängigen Ansprüchen angegebenen Merkmale aufweisen. Vorteilhafte Ausgestaltungen der Erfindung sind in den weiteren, abhängigen Ansprüchen angegeben.

Die Erfindung betrifft ein Verfahren und eine Vorrichtung zur Messwerterfassung einer Mehrfach-Kraftmessvorrichtung, insbesondere einer Mehrfach-Wägevorrichtung, mit mindestens zwei, jeweils mindestens eine Kraftmesszelle aufweisenden Kraftmessmodulen und mit mindestens einer Signalleitung mittels derer die von den Kraftmesszellen erzeugten Messsignale an eine Auswerteeinheit übertragen werden. Diese sind dadurch gekennzeichnet, dass in den jeweiligen Kraftmessmodulen das Messsignal zu einem pulsförmigen Sendesignal moduliert wird und dass dieses Sendesignal über die mindestens eine Signalleitung an die Auswerteeinheit übertragen wird. Dadurch wird erreicht, dass das sensitive und hochpräzise Messsignal der Kraftmesszelle auf einfache Weise in ein gegenüber Störeinflüssen genügend robustes und damit zur Übertragung und zur weiteren Verarbeitung geeignetes Sendesignal umgewandelt wird. Durch die weitgehende Bündelung der Elektronik in der Auswerteeinheit ergeben sich Vorteile bezüglich der Kosten und der Stabilität der Kraftmessvorrichtung. Des Weiteren haben die pulsförmigen Sendesignale den Vorteil, dass sie auf einfache Weise erzeugt werden können und trotzdem den hohen Anforderungen bezüglich Messgenauigkeit und Stabilität genügen.

Durch die Modulation bleibt die Qualität und damit der Informationsgehalt des ursprünglichen Messsignals während der Übertragung zu der Auswerteeinheit und während der weiteren Verarbeitung in genügender Weise erhalten. Störeinflüsse, die beispielsweise während der Signalübertragung auf das modulierte Sendesignal einwirken oder die durch Schaltvorgänge in einem Multiplexer entstehen, können durch eine geeignete Signalverarbeitung in der Auswerteeinheit, beispielsweise durch ein Demodulationsverfahren, in geeigneter Weise reduziert oder gar eliminiert werden. Dabei beinhaltet der Begriff der Modulation sämtliche Verfahren die der Umwandlung der Messsignale in ein entsprechendes Sendesignal dienen, insbesondere auch die Umwandlung mit einfachen Logikbausteinen und einfachen Trägersignalen, welche beispielsweise als Komparator und als konstante Spannung ausgebildet sein können.

Besonders vorteilhaft erweist sich, dass die Qualität des Sendesignals auch bei einem Multiplexer mit hohen Schaltgeschwindigkeiten weitgehend erhalten bleibt. Die hohen Schaltgeschwindigkeiten wiederum erlauben die praktisch gleichzeitige Messung der einzelnen Kraftmessmodule. Das gilt insbesondere für das Verwiegen individueller Wägegüter in automatisierten Prozessen, da im diesem Fall geringe Zeitverzögerungen grosse Auswirkungen in der Genauigkeit der Prozessresultate haben können.

Mit dem Begriff Signalleitung werden alle Arten von elektrischen Leitungen, wie einadrige oder mehradrige Kabel, Litzen oder Drähte, sowie die Führung des elektrischen Stroms über feste Vorrichtungen wie Erdungsschienen, Gehäuse und Verbindungsstangen, bezeichnet, die zur Übertragung elektrischer Signale von den Kraftmessmodulen zur Auswerteeinheit geeignet sind.

Während die aufwändigen elektronischen Bauteile wie Schaltvorrichtung, Multiplexer, Demodulator, Analog-Digital-Wandler, Recheneinheit, Steuer- und Kontrollvorrichtung in der Auswerteeinheit angeordnet sind und gemeinsam von allen Kraftmessmodulen genutzt werden können, befindet sich in den jeweiligen Kraftmessmodulen lediglich eine minimale Anzahl von Elektronikkomponenten, vorzugsweise die Modulationsvorrichtung, zur Erzeugung der Sendesignale. Da die Anzahl der Kraftmessmodule stets grösser als die Anzahl der Auswerteeinheiten ist, wird somit ein einfacher und kostengünstiger Aufbau der gesamten Mehrfach-Kraftmessvorrichtung erreicht.

In einer vorteilhaften Ausgestaltung der Erfindung wird durch die Kraftmesszelle ein analoges Signal erzeugt. Dadurch wird das auf Störungen besonders empfindliche analoge Messsignal der Kraftmesszelle unverzüglich moduliert und damit vor weiteren Qualitätsverlusten geschützt. Ausserdem kann dadurch eine Energie verbrauchende oder/und Wärme erzeugende Umwandlung der Messsignale vermieden werden. Ferner ergibt sich dadurch, dass praktisch die gesamten Elektronikbauteile in der Auswertevorrichtung angeordnet sind eine grössere Kostenersparnis und eine Reduktion der Wärmeerzeugung in den Kraftmessmodulen.

Des Weiteren kann das Messsignal der Kraftmesszelle, vorgängig zur Weiterleitung an die Modulationsvorrichtung, gemäss den Anforderungen der nachgeschalteten Modulationsvorrichtung in der Kraftmesszelle integriert und/oder verstärkt und/oder impedanzgewandelt werden.

In einer bevorzugten Ausgestaltung der Erfindung wird mittels der Modulationsvorrichtung ein puls-weiten-moduliertes (PWM) Sendesignal erzeugt. Diese Signale haben den Vorteil, dass sie auf einfache Weise erzeugt und zuverlässig demoduliert werden können. Beispielsweise kann ein puls-weiten-moduliertes (PWM) Sendesignal mit einem einfachen Komparator durch Vergleichen des Messsignals mit einem sägezahnförmigen Signal erzeugt werden. In diesem Fall wirkt der Komparator als Modulationsvorrichtung, welche das Messsignal auf ein, als konstante Spannung ausgebildetes Trägersignal moduliert. Somit entspricht die Breite der erzeugten Pulse der Amplitude des Messsignals zum Zeitpunkt der Spannungsgleichheit. Die Informationen des Messsignals werden daher in die zeitlichen Ereignisse von aufsteigenden beziehungsweise absteigenden Flanken des Sendesignals umgewandelt. Diese Signalübergänge sind dann robuster gegenüber Störungen und können demzufolge zuverlässiger übertragen und verarbeitet werden als das ursprüngliche Messsignal.

In einer weiteren erfindungsgemässen Ausgestaltung wird das Sendesignal in Form von Zählpulsen erzeugt, dessen Anzahl pro Zeitintervall mit der Amplitude des Messsignals korrespondiert. In dieser Form ist das Sendesignal sehr robust gegenüber Störungen und somit besonders gut zur Übertragung und Verarbeitung von Informationen geeignet. Beispielsweise können diese Zählimpulse auf einfache Weise aus einem geeigneten Taktsignal abgeleitet werden.

In einer weiteren, bevorzugten Ausgestaltung der Erfindung wird das Sendesignal bezüglich eines, gegebenenfalls durch die Auswerteeinheit erzeugten, Taktsignals synchron erzeugt. Dabei kann die entsprechende Synchronisationsvorrichtung sehr einfach aufgebaut sein, beispielsweise als taktgesteuerte Kippstufe. Durch diese Synchronisation kann die Störempfindlichkeit des Sendesignals bezüglich zeitlicher Schwankungen verbessert werden. In bevorzugter Weise wird dabei das Taktsignal durch die Auswerteeinheit erzeugt und an die Kraftmessmodule verteilt um auf diese Weise eine gemeinsame Synchronisation aller Kraftmessmodule zu erreichen.

Die Trennung der Auswerteeinheit von den Kraftmessmodulen und insbesondere von den Kraftmesszellen ist besonders vorteilhaft bei einer grossen Zahl von kompakt angeordneten Kraftmessmodulen, da dann besonders hohe lokale Wärmekonzentrationen auftreten können.

In einer weiteren erfindungsgemässen Ausgestaltung wird das Sendesignal in der Auswerteeinheit in ein digitales Signal gewandelt und dieses digitale Signal weiter ausgewertet. Vorzugsweise wird diese Umwandlung durch einen, in der Auswerteeinheit angeordneten programmierbaren Mikroprozessor übernommen. Dieser Mikroprozessor kann zudem auch die Steuerung und/oder die Kontrolle der einzelnen Kraftmessmodule und/oder der gesamten Kraftmessvorrichtung übernehmen.

Ferner wird in einer weiteren, erfindungsgemässen Ausgestaltung die Übertragung des Sendesignals durch die Auswerteeinheit gesteuert um eine zentrale Steuerung der Übermittlung der Sendesignale zu erreichen. Beispielsweise können die jeweiligen Kraftmessmodule gemäß den Steuerbefehlen der Auswerteeinheit die pulsförmigen Sendesignale in Form von zeitlich begrenzten Signalsequenzen an die Auswerteeinheit übermitteln.

In einer weiteren erfindungsgemässen Ausführung basiert die Modulationsvorrichtung auf dem Prinzip des "integrierenden Charge Balancing" Verfahrens. Bei diesem Verfahren wird ein analoges Eingangssignal integriert indem ein Kondensator eine entsprechende Ladungsänderung erfährt. Zur Kompensation dieser vom Eingangssignal abhängigen Ladungsänderung wird dem Kondensator periodisch ein gegenpoliges Referenzsignal zugeführt. Die Dauer zur Kompensation der Ladungsänderung korrespondiert daher mit dem Amplitudenverlauf des Eingangssignals. Das, auf diese Weise erzeugte Sendesignal genügt hohen Anforderungen an die Messgenauigkeit und bietet den Vorteil einer hohen Störungsimmunität. Weitere Einzelheiten zur technischen Umsetzung dieses Verfahrens sind in der Detailbeschreibung dargelegt.

In einer bevorzugten Ausgestaltung der Erfindung wird das jeweilige Sendesignal durch eine in der Auswerteeinheit angeordneten Schaltvorrichtung, insbesondere durch einen Multiplexer, selektiv zur weiteren Verarbeitung durchgeschaltet. Dadurch kann eine zeitlich beschränkte und gesteuerte Zuteilung der Auswertevorrichtung auf die einzelnen Kraftmessmodule erreicht werden. Vorzugsweise ist diese Schaltvorrichtung als Mikroprozessor ausgebildet; denkbar sind aber auch einfachere Schaltvorrichtungen wie elektromechanische Schalter, Leistungstransistoren oder Logikbausteine.

In einer weiteren Ausgestaltung der Erfindung wird das Messsignal in Bezug auf eine am jeweiligen Kraftmessmodul anliegenden Modulreferenzspannung umgewandelt. Vorzugsweise weist dabei die Auswerteeinheit eine Vorrichtung zur Erzeugung einer Referenzspannung auf, welche dann den Kraftmessmodulen zugeführt wird und dort jeweils als Modulreferenzspannung, insbesondere als weitgehend konstante Modulreferenzspannung gemäss der Beziehung V_{Ref1}=V_{Ref2}= ... = V_{Refn}, anliegt. Das kann beispielsweise durch geeignete Widerstände und oder Leitungen erreicht werden. Des Weiteren kann die Stabilität und Messgenauigkeit der gesamten Kraftmessvorrichtung dadurch erhöht werden, dass die Auswerteeinheit eine stabilisierte, insbesondere eine gegen Temperatureinflüsse und/oder gegen Schwankungen der Stromversorgung stabilisierte, Referenzspannung erzeugt, welche den jeweiligen Kraftmessmodulen zugeführt wird.

In einer weiteren, bevorzugten Ausgestaltung der Erfindung ist jede Modulationsvorrichtung mit einer individuellen Signalleitung mit der Auswerteeinheit verbunden, über welche das jeweilige Sendesignal an die Auswerteeinheit übertragbar ist. Durch diese Trennung der einzelnen Signalleitungen können Interferenzen zwischen den verschiedenen Sendesignalen vermieden werden. Ferner können, dank der Verbesserung der Störempfindlichkeit durch das Modulationsverfahren kostengünstige Signalleitungen eingesetzt werden, beispielsweise Leitungen mit dünnerem.

In einer weiteren, bevorzugten Ausgestaltung der Erfindung wird die Auswerteeinheit weitgehend isoliert und/oder weitgehend räumlich getrennt und/oder weitgehend thermisch isoliert von den Kraftmesszellen angeordnet ist. Dadurch wird die Übertragung von Störungen, insbesondere die Übertragung von thermischen Einflüssen, der Auswerteeinheit auf die jeweiligen Kraftmessmodule weitgehend unterbunden und dadurch eine Beeinträchtigung der Messgenauigkeit und der Stabilität der Kraftmesszellen vermieden. Die räumliche Trennung wird vorzugsweise durch eine genügend grosse räumliche Distanz mit entsprechend verlängerten Signalleitungen erreicht. Denkbar ist aber auch eine Entkoppelung durch Trennwände, separate Gehäuse oder abschirmende Isolationsmaterialien.

In einer weiteren, bevorzugten Ausgestaltung der Erfindung sind die Modulationsvorrichtungen jeweils mit einer gemeinsamen Signalleitung verbunden, über die die Sendesignale, gegebenenfalls kontrolliert durch eine Kommunikationssteuerung, an die Auswerteeinheit übertragen werden. In diesem Fall kann der Verkabelungsaufwand deutlich reduziert werden. Die verschiedenen Sendesignale können durch individuell zugeordnete, vorzugsweise synchronisierte Zeitintervalle oder individuell zugeordnete Frequenzbänder voneinander getrennt werden. Ausserdem könnten auch komplexere Verfahren eingesetzt werden, wie sie in der leitungsgebundenen Nachrichtentechnik oder der Funkübertragungstechnik gebräuchlich sind. So ist auch denkbar, dass alle Sendesignale der Kraftmessmodule beliebig zusammengemischt, zur Auswerteeinheit übertragen und dort anhand von charakteristischen Mustern wieder getrennt und zugeordnet werden. Da die Auswerteeinheit von allen Kraftmessmodulen gemeinsam genutzt wird, können dort die Sendesignale mit relativ hohem Aufwand ausgewertet werden und trotzdem kann eine insgesamt kostengünstige Kraftmessvorrichtung erreicht werden.

In einer weiteren, erfindungsgemässen Ausgestaltung ist mindestens ein Kraftmessmodul abschaltbar und/oder auswechselbar, während mindestens ein weiteres Kraftmessmodul seinen Messbetrieb fortsetzt. Dadurch ist es beispielsweise möglich ein Kraftmessmodul während des Betriebs der Kraftmessvorrichtung auszuwechseln während die anderen Kraftmessmodule ihren Betrieb fortsetzen . Besonders beim Einsatz in industriellen Anlagen ergibt sich der grosse Vorteil, dass dadurch Betriebsunterbrüche der gesamten Anlage vermieden oder zumindest auf ein unvermeidbares Minimum reduziert werden können.

Die einzelnen Kraftmessmodule können in beliebiger Weise angeordnet sein, beispielsweise reihenförmig, flächenförmig, dreidimensional verteilt, zufällig verteilt, ringförmig oder arrayförmig. Unter arrayförmig ist dabei eine regelmässige Anordnung zu verstehen, beispielsweise eine reihenförmige, ein-dimensionale Anordnung wie eine Zeile oder eine flächenförmige, zwei-dimensionale Anordnung wie eine Matrix. Denkbar ist auch eine drei-dimensionale Anordnung mit mehreren Lagen von übereinander liegenden zwei-dimensionalen Anordnungen.

Einzelheiten der erfindungsgemässen Kraftmessvorrichtung, des erfindungsgemässen Kraftmessmoduls und des erfindungsgemässen Verfahrens ergeben sich anhand der Beschreibung der in den Zeichnungen dargestellten Ausführungsbeispiele. Es zeigen:
- Fig. 1: zeigt in perspektivischer Darstellung eine Mehrfach-Kraftmessvorrichtung mit sechs Kraftmessmodulen, welche arrayförmig angeordnet sind und welche jeweils über eine Signalleitung mit einer Auswerteeinheit verbunden sind;
- Fig. 2: eine Prinzipzeichnung einer Mehrfach-Kraftmessvorrichtung entsprechend Figur 1 mit zwei Kraftmessmodulen im Schnitt deren Messwerterfassung auf dem Prinzip der elektromagnetischen Kraftkompensation basiert und die eine Modulationsvorrichtung zur Erzeugung von Sendesignalen aufweisen und mit einer Verteilung einer zentral erzeugten Referenzspannung;

- Fig. 3: ein vereinfachtes Schaltschema einer Mehrfach-Kraftmessvorrichtung entsprechend Figur 2, jedoch mit einer Vielzahl n von Kraftmessmodulen, welche jeweils pulsförmige Sendesignale an eine Multiplexvorrichtung in der Auswerteeinheit übermitteln;
- Fig. 4: eine starke vereinfachte Prinzipzeichnung einer Mehrfach-Kraftmessvorrichtung entsprechend Figur 3, jedoch mit zwei Kraftmessmodulen bei welchen die Modulationsvorrichtung nach dem Prinzip des "integrierenden Charge-balancing" Verfahrens arbeitet und ein (1) Zählimpulse aufweisendes, (2) ein synchronisiertes puls-weiten-moduliertes (SWI) und (3) ein puls-weiten-moduliertes (PWM) Sendesignal erzeugt;
- Fig. 5: eine weitere Ausführungsform mit zwei Kraftmessmodulen entsprechend Figur 4 und Anschlusspunkt (2), bei der jedoch das puls-weiten-modulierte Signal des ersten Kraftmessmoduls rückgekoppelt und das puls-weiten modulierte Signal des zweiten Moduls über eine Kippstufe zur Auswerteeinheit übertragen wird;
- Fig. 6: eine weitere Ausgestaltung entsprechend Figur 5, bei der jedoch das pulsweiten-modulierte Signal des zweiten Moduls direkt zur Auswerteeinheit übertragen und dort einer Kippstufe zugeführt wird;
- Fig. 7: eine weitere Ausgestaltung entsprechend Figur 6, bei der jedoch in der Auswerteeinheit ein puls-weiten-moduliertes Signal erzeugt wird, welches an die Kraftmessmodule geleitet und dort zur Rückkoppelung eingesetzt wird.

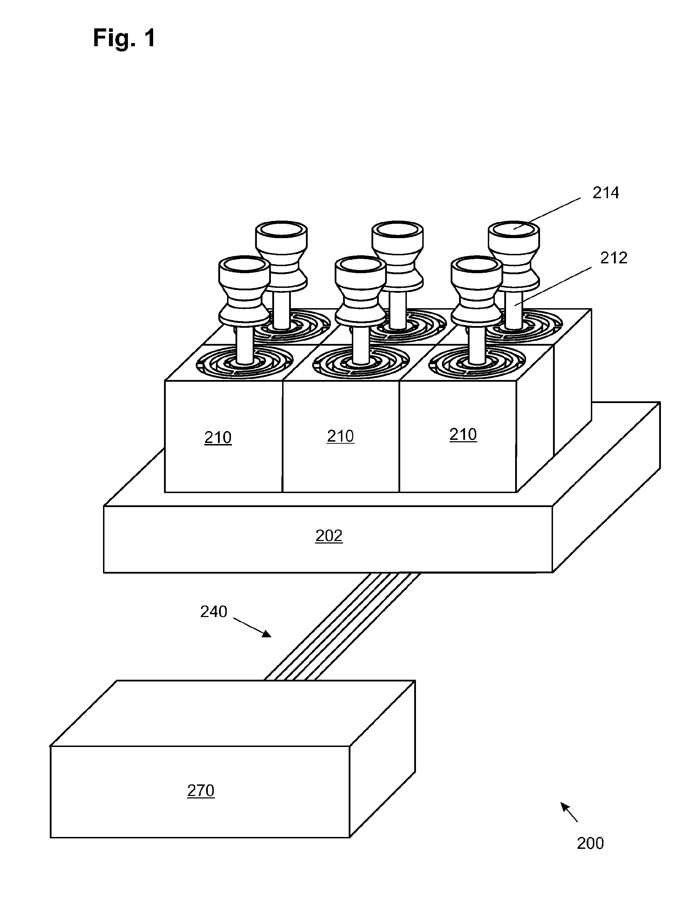

Die Figur 1 zeigt in perspektivischer Darstellung eine Mehrfach-Kraftmessvorrichtung 200 mit sechs, arrayförmig angeordnete Kraftmessmodulen 210. Die Kraftmessmodule 210 weisen je eine, hier nicht dargestellte, im Innern des Kraftmessmoduls 210 eingebaute Kraftmesszelle 220 auf, die mit einem nach aussen führenden Kraftübertragungsgestänge 212 verbunden ist. Ausgehend von einer Kraftmesszelle 220 erstreckt sich jeweils entgegen der Lastrichtung das Kraftübertragungsgestänge 212, an dessen Ende jeweils ein Kraftaufnehmer 214 angebracht ist. Oberhalb der Kraftaufnehmer 214 befindet sich üblicherweise die nicht dargestellten, individuellen Wägegüter beziehungsweise die Lasten.

Jedes Kraftmessmodul 210 ist an einer Aufnahmestruktur in Form einer Grundplatte 202 befestigt. Die Kraftmessmodule sind 210 lösbar mit der Grundplatte 202 verbunden und können bei Bedarf gegen gleich geartete Kraftmessmodule 210 ausgewechselt werden, beispielsweise im Servicefall oder, wenn die Mehrfach-Kraftmessvorrichtung 200 an einen anderen Lastbereich angepasst werden soll.

Die Kraftmesszelle 220 wandelt eine auf sie einwirkende Kraft in ein dazu korrespondierendes Messsignal S_{M1}, S_{M2} um. Diese Messsignal S_{M1}, S_{M2} wird dann in ein Sendesignal in den einzelnen Kraftmessmodule 210 geeignet umgeformt und über mindestens eine Signalleitung 240 an die Auswerteeinheit 270 übermittelt.

Die Auswerteeinheit 270 ist in einiger Distanz von den Kraftmessmodulen 210 angeordnet, um eine gegenseitige Störung von Elektronik der Auswerteeinheit 270 und der Kraftmessmodule 210 zu vermeiden. Diese Störungen können auf vielfältige Weise auftreten beispielsweise als elektromagnetische Felder, Wärmestrahlung, Wärmekonvektion oder Erschütterungen.

In der Auswerteeinheit 270 werden die über die Signalleitung 240 übermittelten Signale ausgewertet und gegebenenfalls in digitale Werte umgewandelt und/oder geeignet umgeformt. Die Ergebnisse der Auswertung können auf vielfältige Weise zur weiteren Verarbeitung weitergegeben werden, beispielsweise an eine Anzeigevorrichtung, an eine Anlagensteuerung oder an einen Leitrechner.

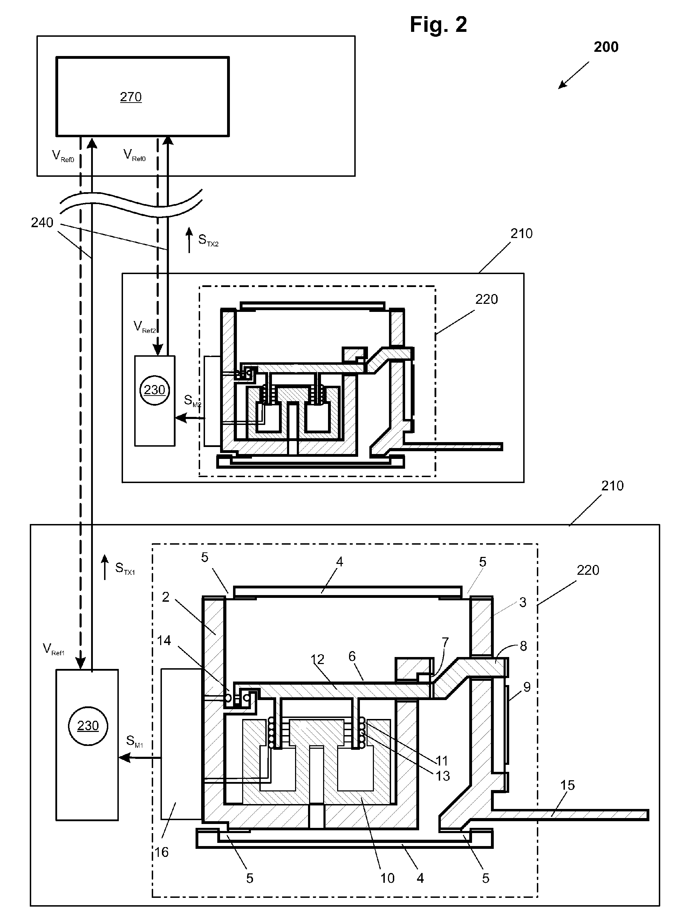

Figur 2 zeigt stark schematisiert eine Prinzipzeichnung einer Mehrfach-Kraftmessvorrichtung 200 mit zwei identischen Kraftmessmodulen 210 entsprechend Figur 1. Dabei basieren die Kraftmessmodule 210 auf dem Prinzip der elektromagnetischen Kraftkompensation und eignen sich daher besonders für die Verwendung in der Wägetechnologie, insbesondere zur hoch-präzisen Gewichtsbestimmung.

Das Kraftmessmodul 210 weist eine Kraftmesszelle 220 auf, welche wiederum eine Vorrichtung zur Kraftübertragung mit einer Parallelführung mit einem feststehenden Bereich 2 und einem vertikal auslenkbaren Bereich 3, welche jeweils an den Enden eines Paars von Lenkern 4 über Biegelager 5 angelenkt sind, aufweist. Der vertikal auslenkbare Bereich 3 weist einen zur Aufnahme einer zu messenden Last dienenden Ausleger 15 auf. Die Normalkomponente der von einer Last bewirkten Kraft wird vom vertikal auslenkbaren Bereich 3 durch ein Koppelelement 9 auf den kurzen Hebelarm 8 des Hebels 6 übertragen. Der Hebel 6 ist mittels eines Biegelagers 7 an einem Teil des feststehenden Bereichs 2 abgestützt. Die Kraftmesszelle weist ferner ein topfförmiges Permanentmagnetsystem 10, das in fester Verbindung mit dem feststehenden Teil 2 angeordnet ist, und über einen Luftspalt 11 verfügt, auf. Im Luftspalt 11 ist eine mit dem längeren Hebelarm 12 des Hebels 6 verbundene Spule 13 angeordnet. Die Spule 13 wird von einem Kompensationsstrom durchflossen, dessen Mass von der auf den Hebel 6 einwirkenden Kraft abhängt. Die Lage des Hebels 6 wird von einem opto-elektrischen Positionsgeber 14 gemessen, der mit einer Regeleinrichtung 16 verbunden ist, welche den Kompensationsstrom in Abhängigkeit der zugeführten Signale des opto-elektrischen Positionsgebers 14 derart regelt, dass der Hebel 6 stets in gleicher Lage gehalten oder nach einer Laständerung in diese wieder zurückgeführt wird. Durch das Prinzip der Kraftkompensation kann eine sehr hohe Messgenauigkeit erreicht werden, was insbesondere beim Abmessen kleinster Mengen von Wägegut besonders vorteilhaft ist.

Des Weiteren kann das Kraftmessmodul auch als direkt wirkende Kraftmessvorrichtung ausgebildet sein. Dabei wird auf eine Kraftübertragung via Hebel 6 verzichtet indem die Spule 13 direkt mit dem nach aussen führenden Kraftübertragungsgestänge 212 verbunden ist. Dabei wird der Kompensationsstrom derart geregelt, dass die Kompensationskraft der auf das Kraftübertragungsgestänge einwirkenden Last entgegenwirkt und somit das Kraftübertragungsgestänge in einer konstanten Position gehalten wird.

Das von der Regeleinrichtung 16 abgegebene Messsignal S_{M1} charakterisiert die auf das Kraftmessmodul einwirkende Kraft. Erfindungsgemäß wird dieses Signal an eine Modulationsvorrichtung 230, welche mit der Kraftmesszelle 220 und insbesondere mit der Regeleinrichtung 16 verbunden ist, weitergeleitet. Das Messsignal S_{M1} wird dort mit einem geeigneten Trägersignal zu einem pulsförmigen Sendesignal S_{TX1} moduliert. Das pulsförmige Sendesignal S_{TX1} wird dann, wie bereits in Zusammenhang mit Figur 1 beschrieben, über die Signalleitung 240 an die Auswerteeinheit 270 übertragen (durchgezogene Pfeile). In gleicher Weise werden auch die Messwerte des zweiten Kraftmessmoduls 210 oder der weiteren Kraftmessmodule 210 jeweils mittels Modulationsvorrichtungen 230 moduliert und als Sendesignal S_{TX2} an die Auswerteeinheit 270 übermittelt.

Des Weiteren ist die Auswerteeinheit 270 in der Lage eine Referenzspannung V_{Refo} zu erzeugen und diese an die Kraftmessmodule 210 weiterzuleiten (gestrichelte Pfeile). Diese Referenzspannung V_{Ref0} liegt dann bei den Kraftmessmodulen 210 als Modulreferenzspannung V_{Ref1} und V_{Ref2} an. In einer bevorzugten Ausführungsform wird die Verteilung der Referenzspannung V_{Ref0} durch geeignete Maßnahmen, beispielsweise geeignete Kabellängen, zusätzliche Widerstände, derart eingestellt, dass bei allen Kraftmessmodulen 210 die gleiche Modul Referenzspannung V_{Ref1}=V_{Ref2} anliegt.

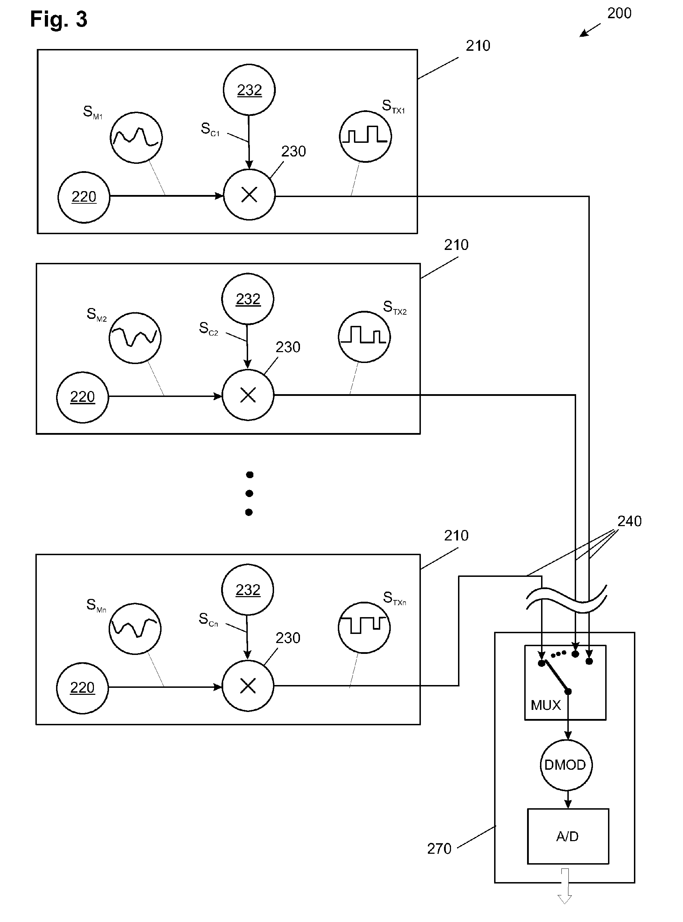

Figur 3 zeigt ein vereinfachtes Schaltschema einer Mehrfach-Kraftmessvorrichtung 200 n Kraftmessmodulen 210 welche jeweils eine Modulationsvorrichtung 230 zur Erzeugung von pulsförmigen Sendesignalen S_{TX1} ... S_{TXn} aufweisen. Der Index n steht für eine beliebige natürliche Zahl welche größer oder gleich 2 ist. Vorzugsweise sind alle Kraftmessmodule 210 identisch aufgebaut und beliebig auswechselbar.

Im Kraftmessmodul 210 ist die Modulationsvorrichtung 230 mit der Kraftmesszelle 220 elektrisch verbunden, sodass das Messsignal S_{TX1} der Kraftmesszelle 220 der Modulationsvorrichtung 230 zugeführt werden kann. Durch die Modulationsvorrichtung 230 wird das Messsignal S_{M1} mit einem Trägersignal S_{C1}, welches durch eine Trägersignalquelle 232 erzeugt wird, moduliert und somit ein pulsförmiges Sendesignal S_{TX1} erzeugt. Das Trägersignal S_{C1} kann im einfachsten Fall durch eine konstante Spannung gebildet werden, denkbar sind aber auch komplexere Formen von Signalen, beispielsweise sinusförmige Signale, rechteckförmige Signale oder allgemein geformte, periodische Signale. Wie im Vorangehenden beschrieben, wird auch in diesem Fall das Sendesignal S_{TX1} über die Signalleitung 240 an die Auswerteeinheit 270 übermittelt und dort ausgewertet.

Die zwei bis n weiteren Module sind identisch aufgebaut und erzeugen die entsprechenden Sendesignale S_{TX2}, S_{TX3}, ... S_{TXn} in gleicher Weise. Diese Sendesignale werden dann jeweils über getrennte Signalleitungen 240 an die Auswerteeinheit übertragen. Es ist aber auch denkbar, dass alle Sendesignale S_{TX1}, S_{TX2}, ... S_{TXn} über eine gemeinsame Signalleitung 240 an die Auswerteeinheit 270 übertragen werden. In diesem Fall wären dann die Sendesignale S_{TX1}, S_{TX2}, ... S_{TXn} der verschiedenen Kraftmessmodule 210 durch individuell zugeordnete Zeitintervalle oder individuell zugeordnete Frequenzbänder der Trägersignale S_{C1}, S_{C2}, ... S_{Cn} zu trennen. Außerdem könnten auch weitere Modulationsverfahren, wie sie in der leitungsgebundenen Nachrichtentechnik oder der Funkübertragungstechnik gebräuchlich sind, beispielsweise CDMA oder OFDMA, eingesetzt werden.

Die Auswerteeinheit 270 weist eine Multiplexvorrichtung MUX auf, mit der die Sendesignale S_{TX1}, S_{TX2}, ... S_{TXn} der verschiedenen Kraftmessmodule 210 selektiv zur weiteren Verarbeitung durchgeschaltet werden können. Die Steuerung der Multiplexvorrichtung MUX kann durch einen nicht dargestellten Mikroprozessor gesteuert werden oder der Mikroprozessor selbst kann die Aufgabe der Multiplexvorrichtung MUX übernehmen. In diesem Ausführungsbeispiel wird das Ausgangssignal der Multiplexvorrichtung MUX einer Demodulationsvorrichtung DMOD zugeführt, welche das durch die Multiplexvorrichtung MUX geschaltete Sendesignal demoduliert und somit das ursprüngliche Messsignal des jeweiligen Kraftmessmoduls 210 rekonstruiert. Dieser Demodulationsvorgang kann im einfachsten Fall aus einer einfachen Filterung bestehen, es können aber auch komplizierte Verfahren eingesetzt werden um beispielsweise die Unzulänglichkeiten und/oder Qualitätseinbussen einer sehr stark vereinfachten oder kostengünstig ausgestalteten Modulationsvorrichtung 230 zu kompensieren. Denkbar ist aber auch, dass auf die Demodulationsvorrichtung DMOD verzichtet wird und das Sendesignal zuerst in eine digitale Form gewandelt und dann erst demoduliert oder aber auch direkt ausgewertet wird.

Schließlich wird in diesem Ausführungsbeispiel das Signals der Demodulationsvorrichtung DMOD einem Analog-Digital-Wandler A/D zugeführt, welcher ein, dem ursprüngliche in Messsignal S_{M1}, S_{M2}, ... S_{Mn} entsprechendes digitales Signal S_{D} erzeugt. Dieses digitale Signal S_{D} wird anschliessend an eine nachfolgende Verarbeitungseinheit, beispielsweise eine Recheneinheit, einen Leitrechner, eine Prozesssteuerung, eine Kommunikationsvorrichtung oder eine Anzeigevorrichtung beziehungsweise eine Anzeigeeinheit weitergeleitet.

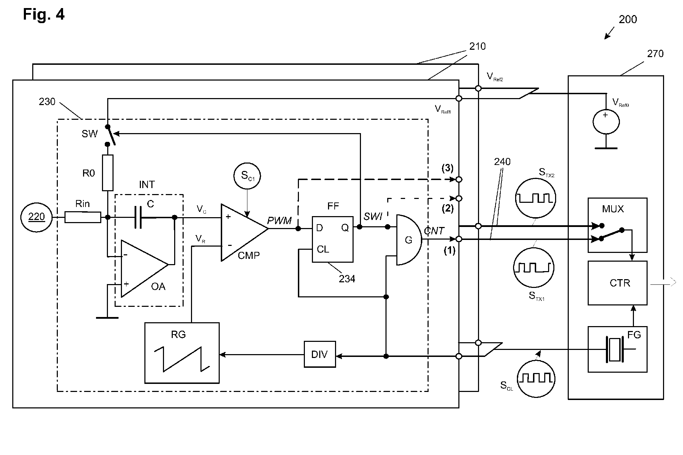

Eine weitere Ausgestaltung der erfindungsgemässen Mehrfach-Kraftmessvorrichtung ist in Figur 4 dargestellt. Diese Anordnung entspricht Figur 3, bei welcher die jeweiligen Modulationsvorrichtung nach dem Prinzip des integrierenden Charge-balancing Verfahrens arbeitet, welches im Folgenden beschrieben wird.

Zur Messwertumwandlung des Messsignals S_{M1} weist die Modulationsvorrichtung 230 einen Integrator INT mit einem Operationsverstärker OA auf, dessen Ausgang über einen Kondensator C mit dessen invertierendem Eingang verbunden ist, dem über einen Eingangswiderstand Rin das Messsignals S_{M1} und über einen Referenzwiderstand R0 eine Referenzspannung U_{ref1} zuführbar ist. Während der Eingangswiderstand Rin permanent mit der Eingangsspannung beaufschlagt ist, ist der Referenzwiderstand R0 über eine Schaltvorrichtung SW mit einer Modulreferenzspannung V_{Ref1} verbunden.

Der Integrator INT ist mit einem nachfolgenden Komparator CMP verbunden, durch den die Ausgangsspannung V_{C} des Integrators INT mit der Ausgangsspannung V_{R} eines Rampengenerators RG verglichen wird, welch letztere periodisch, innerhalb einer Periodendauer T0, einen Spannungsbereich durchläuft. Sobald die ansteigende Ausgangsspannung V_{R} des Rampengenerators RG die Ausgangsspannung V_{C} des Integrators INT kreuzt und übersteigt, kippt die Ausgangsspannung des Komparators CMP von einem ersten Spannungswert auf einen zweiten Spannungswert und unterteilt außerdem die Periodendauer T0 in einen ersten Periodenanteil T1 und in einem zweiten Periodenanteil T2. Somit wird durch den Komparator CMP ein pulsförmiges Signal erzeugt, dessen Pulsweite durch die integrierte Ladung des dem Integrator INT befindlichen Kondensators C bestimmt ist. Integrator INT und Komparator C wirken somit als Modulationsvorrichtung 230 indem sie das Messsignal S_{M1} mit einem Trägersignal S_{c1}, welches in diesem Ausführungsbeispiel als eine einfache Spannungsquelle mit einer weitgehend konstanten Spannung ausgebildet ist, modulieren und somit ein puls-weiten-moduliertes Ausgangssignal PWM am Ausgang des Komparators C erzeugen.

Des Weiteren wird das puls-weiten-modulierte Ausgangssignal PWM einer nachgeschalteten Kippstufe FF zugeführt und anschliessend zur Steuerung der Schaltvorrichtung SW eingesetzt. Mit dem Umschalten der Kippstufe FF wird die Arbeitsperiode T0 in zwei Anteile zerlegt. Im ersten Periodenanteil T1 ist die Kippstufe FF gesetzt und im zweiten Periodenanteil T2 ist die Kippstufe FF zurückgesetzt. Innerhalb des ersten Periodenanteils T1 wird die vom Messsignal S_{M1} während des zweiten Periodenanteils T2 verursachte Änderung der Ladung des Kondensators C mittels eines dem Integrator INT über einen Referenzwiderstand R0 zugeführten Stromes kompensiert. Dabei dauert es jeweils mehrere Arbeitsperioden T0 bis die dem Kondensator C innerhalb der beiden Periodenanteile T1, T2 zugeführten und entnommenen Ladungen balanciert sind.

Sowohl die Kippstufe FF als auch eine Teilungsstufe DIV mit dem nachgeschalteten Rampengenerator RG werden mittels eines Taktsignals S_{CL} synchronisiert, welches von einem Taktgenerator FG erzeugt wird. Dadurch ist gewährleistet dass die Pulsweite des Ausgangssignals SWI der Kippstufe FF stets ein ganzzahliges Vielfaches des Taktintervalls des Taktsignals S_{CL} beträgt. Die Kippstufe wirkt somit als Synchronisationsvorrichtung 234 welche das Ausgangssignal PWM des Komparators CMP mit dem Taktsignal S_{CL} synchronisiert und daraus das synchronisierte, puls-weiten-modulierte Ausgangssignal SWI der Kippstufe FF erzeugt.

Mit dem synchronisierten Ausgangssignal SWI der Kippstufe FF wird die oben genannte Schaltvorrichtung SW gesteuert um während den verschiedenen Periodenanteilen T1 und T2 die Modulreferenzspannung V_{ref1} jeweils zuzuschalten beziehungsweise zu trennen.

Des Weiteren ist der Kippstufe FF ein Gatter G nachgeschaltet, welches ebenfalls mittels des Taktsignals S_{CL} synchronisiert ist und welches bei gesetzter Kippstufe das Taktsignal S_{CL} in Form von Zählimpulsen CNT weiterleitet. Dabei sind die innerhalb des ersten Periodenanteils T1 verstreichende Anzahl Zählimpulse CNT, während der die durch das Messsignal S_{M1} verursachte Ladungsänderung des Kondensators C kompensiert wird, ein Mass für die Grösse des Messsignals S_{M1}. Das Ausgangssignal SWI der Kippstufe FF wird somit in das pulsförmige Ausgangssignal CNT des Gatters umgewandelt, welches in Form von Zählimpulsen ausgebildet ist.

In einer ersten Ausführungsform wird das Ausgangssignal CNT des Gatters G über den Anschlusspunkt (1) als Sendesignal S_{TX1} auf die Signalleitung 240 gegeben. Dieses wird nach Übermittlung an die Auswerteeinheit 270 über eine, bereits in Figur 3 beschriebene Multiplexvorrichtung MUX zugeführt. Somit wird jedem Kraftmessmodul 210 ein Zeitabschnitt zugewiesen, in welchem die jeweiligen Sendesignale S_{TX1}, ... S_{TXn} zur weiteren Verarbeitung durchgeschaltet werden.

Das Ausgangssignal der Multiplexvorrichtung MUX wird einem Zähler CTR zugeführt, welcher für jede Arbeitsperiode T0 die innerhalb des ersten Periodenanteils T1 auftretenden Zählimpulse zählt. Ausserdem kann der Zähler synchronisiert, beispielsweise bezüglich des Taktgenerators FG oder des Ausgangs der Teilungsstufe DIV, zurückgesetzt werden. Die Anzahl der innerhalb des ersten Periodenanteils T1 gezählten Zählimpulse oder eine dazu korrespondierende Zahl wird anschliessend an eine nachfolgende Verarbeitungseinheit, beispielsweise eine Recheneinheit, einen Leitrechner, eine Prozesssteuerung, eine Kommunikationsvorrichtung oder eine Anzeigevorrichtung beziehungsweise eine Anzeigeeinheit weitergeleitet.

In einer zweiten Ausführungsform kann das Ausgangssignal SWI der Kippstufe FF über den Anschlusspunkt (2) (siehe Figur 4) ausgekoppelt werden (gestrichelter Pfeil). Die Signalleitung 240 ist dann an den Anschlusspunkt (2) angeschlossen. Somit wird das Sendesignal S_{TX1} durch das synchronisierte, puls-weiten-modulierte Ausgangssignal SWI der Kippstufe FF gebildet und über die Signalleitung 240 zur Auswerteeinheit 270 übertragen.

In einer dritten Ausführungsform kann das Ausgangssignal PWI des Komparators CMP über den Anschlusspunkt (3) ausgekoppelt werden (gepunkteter Pfeil). Die Signalleitung 240 wird dazu an den Anschlusspunkt (3) angeschlossen. Das Sendesignal S_{TX1} wird folglich durch das puls-weiten-modulierte Ausgangssignal PWI des Komparators CMP gebildet und über die Signalleitung 240 zur Auswerteeinheit 270 übertragen.

In analoger Weise können auch bei dem zweiten Kraftmessmodul 210 synchronisierte und puls-weiten-modulierte Signale ausgekoppelt werden. Außerdem kann bei der zweiten und dritten Ausführungsform auf das Gatter G verzichtet und somit eine Vereinfachung der Schaltung in den Kraftmessmodulen 210 erreicht werden.

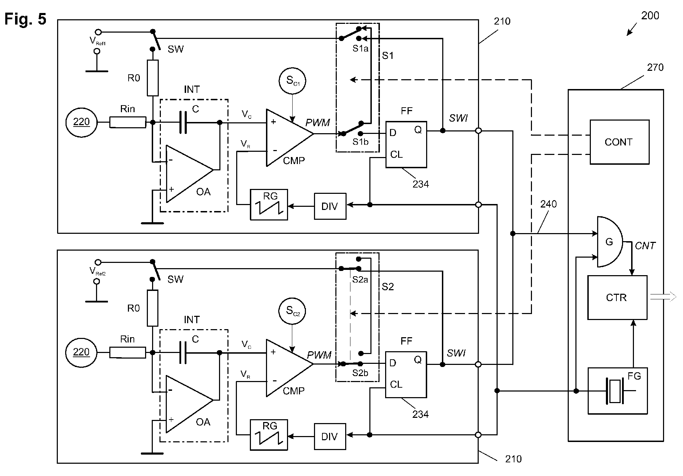

Figur 5 zeigt eine weitere Ausführungsform mit zwei Kraftmessmodulen 210 entsprechend Figur 4 und Anschlusspunkt (2). Bei dieser Ausführung werden jedoch die puls-weiten-modulierte (PWM) Signal in den einzelnen Kraftmessmodulen 210 über Schaltgruppen S1 und S2 gesteuert, welche jeweils ein erstes Schaltelement S1 a beziehungsweise S2a und ein zweites Schaltelement S1 b beziehungsweise S2b aufweisen.

Das puls-weiten-modulierte (PWM) Signal des erste Kraftmessmoduls 210 wird über das zweite Schaltelement S1 b und das erste Schaltelement S1 a zur Steuerung der Schaltvorrichtung SW rückgekoppelt, während das puls-weiten-modulierte (PWM) Signal des zweiten Kraftmessmoduls 210 über das zweite Schaltelement S2b an die entsprechende Kippstufe FF weitergeleitet wird. Das synchronisierte, puls-weiten-modulierte (SWI) Signal der Kippstufe FF wird dann, einerseits über das Schaltelement S2a zur Steuerung der Schaltvorrichtung SW rückgekoppelt und andererseits, wie bereits anhand der Figur 4 beschrieben, über die Signalleitung 240 an die Auswerteeinheit 270 übertragen.

Durch einen synchron über die Kraftmessmodule 210 durchgeführten Schaltvorgang werden die Rollen des ersten und des zweiten Kraftmessmoduls 210 vertauscht. Das synchronisierte, puls-weiten-modulierte (SWI) Signal des ersten Kraftmessmoduls wird dann sowohl über das Schaltelement S1 a zur Steuerung der Schaltvorrichtung SW rückgekoppelt als auch über die Signalleitung 240 an die Auswerteeinheit 270 übertragen während das puls-weiten-modulierte (PWM) Signal des zweiten Kraftmessmoduls über die zweite Schaltgruppe S2 zur Steuerung der Schaltvorrichtung SW rückgekoppelt wird.

Die Schaltelemente S1 a, S1 b, S2a, S2b der Schaltgruppen S1 und S2 sind untereinander gekoppelt, so dass die jeweiligen Schaltelemente S1 a, S1 b und S1 a, S1 b im Wesentlichen gleichzeitig die Schaltvorgänge durchführen. In diesem Beispiel werden die Schaltvorgänge durch eine zentrale Kontrolleinheit CONT, welche in der Auswerteeinheit 270 angeordnet ist, gesteuert. Dadurch wird erreicht, dass die Schaltgruppen S1 und S2 der Kraftmessmodule 210 gleichzeitig geschaltet werden. Vorzugsweise sind die Schaltvorrichtungen und deren Schaltelemente als elektronische Schaltelemente, beispielsweise als Ausgänge eines Prozessors, ausgebildet.

Dieses beschriebene Prinzip lässt sich in analoger Weise auf eine Mehrfach-Kraftmessvorrichtung 200 mit beliebig vielen Kraftmessmodulen 210 fortsetzen. Durch die gesteuerte Schaltgruppen S1, S2 wird erreicht, dass während des Betriebs der Mehrfach-Kraftmesssvorrichtung 200 jeweils ein Kraftmessmodul 210 mit der Auswerteeinheit 270 verbunden ist und gleichzeitig die andere Kraftmessmodule 210 den Betrieb gemäß dem Charge Balancing Verfahren fortsetzen.

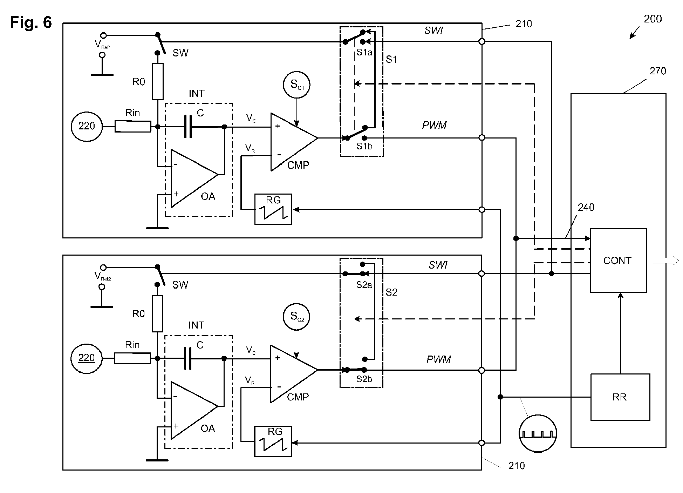

Figur 6 zeigt eine weitere Ausgestaltung entsprechend Figur 5 bei der jedoch das puls-weiten-modulierte (PWM) Signal nicht über eine Kippstufe FF sondern direkt zur Auswerteeinheit übertragen und dort der zentralen Kontrolleinheit CONT zugeführt wird. Diese Kontrolleinheit CONT übernimmt dann die weitere Verarbeitung der Sendesignale S_{TX1}, S_{TX2}, ... S_{TXn} und erzeugt daraus und aus einem zugeführten Taktsignal, ein synchronisiertes, puls-weiten-moduliertes (SWI) Signal. Dieses Signal wird dann, vorzugsweise über eine gemeinsame Verteilleitung, an die einzelnen Kraftmessmodule 210 übertragen. In den Kraftmessmodulen wird dann das synchronisierte, puls-weiten-modulierte (SWI) Signal via das erste Schaltelement S1 a, S1 b zur Steuerung der Schaltvorrichtung SW eingesetzt, falls dieses Schaltelement S1 a, S1 b durchgeschaltet ist. Die Kontrolleinheit CONT übernimmt neben der weiteren Verarbeitung des Sendesignals S_{TX1}, S_{TX2}, ... S_{TXn} und der Erzeugung des synchronisierten, puls-weiten-modulierten (SWI) Signals die Steuerung der Schaltgruppen S1, S2 in den einzelnen Kraftmessmodulen 210.

In diesem Ausführungsbeispiel weist die Auswertevorrichtung 270 ausserdem einen Ramp-Reset Generator RR auf, welcher ein Reset-Signal erzeugt. Dieses Reset-Signal wird dann anstelle des zuvor beschriebenen Taktsignals S_{CL}, vorzugsweise über eine gemeinsame Verteilleitung, an die einzelnen Kraftmessmodule 210 übertragen und dort zum Zurücksetzen der Rampengeneratoren RG verwendet. Dabei erzeugen die Rampengeneratoren RG ausgehend von einer Startspannung eine kontinuierlich ansteigende Spannung V_{R}, bis sie einen Steuerbefehl, vorzugsweise den Impuls eines Reset-Signals, erhalten um daraufhin auf die Startspannung zurückzufallen und von neuem beginnen.

Durch die zentrale Erzeugung des Reset-Signals kann auf die Teilungsstufe DIV in den einzelnen Kraftmessmodulen 210 verzichtet werden. Außerdem ergibt sich für das Reset-Signal eine wesentlich tiefere Frequenz beziehungsweise eine wesentlich längere Periodendauer als für das Taktsignal, welches zur Synchronisation der Sendesignale verwendet wird. Somit ergeben sich weniger Störungen für das Sendesignal und somit eine höhere Messgenauigkeit und Stabilität der Mehrfach-Kraftmessvorrichtung.

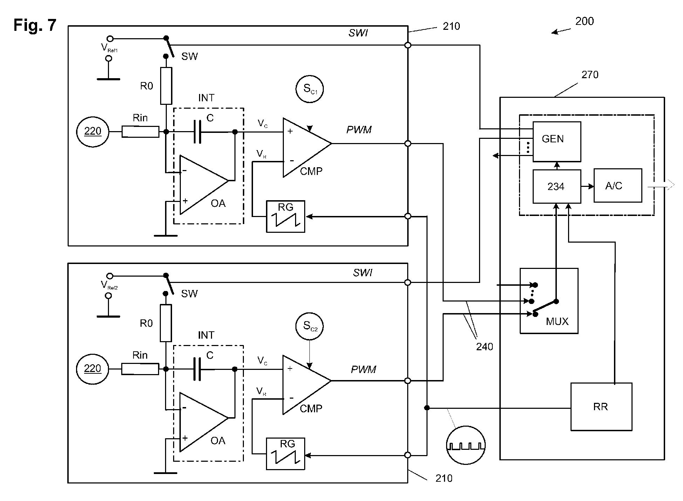

Fig. 7 zeigt eine weitere Ausgestaltung entsprechend Figur 6, bei der jedoch die Auswerteeinheit eine Multiplexvorrichtung MUX und einen PWM Generator aufweist. Die Multiplexvorrichtung MUX erlaubt das selektive Durchschalten der Sendesignale S_{TX1}, S_{TX2}, ... S_{TXn} zur weiteren Verarbeitung. Das durchgeschaltete Sendesignal wird via eine Synchronisationsvorrichtung 234 einerseits an einen Analog-Digital-Wandler A/D und andererseits an einen PWM-Generator GEN weitergeleitet.

Der PWM-Generator GEN erzeugt jeweils für jedes Kraftmessmodul 210 ein individuelles und synchronisiert puls-weiten-moduliertes Signal SWI. Diese Signale werden dann über individuelle Signalleitungen an die Kraftmessmodule 210 weitergeleitet und dort zur Rückkoppelung der Schaltvorrichtung SW verwendet.

Die jeweiligen synchronisierten, puls-weiten-modulierten Signale SWI werden während bestimmten Zeitintervallen fortlaufend und gleichförmig, entsprechend einem konstanten Tastverhältnis, erzeugt. Am Ende des Zeitintervalls, typischerweise in regelmässigen, zyklischen Abständen, werden diese Signale den aktuellen Erfordernissen angepasst. Dazu übernimmt der PWM-Generator GEN das empfangene synchronisierte, puls-weiten-modulierte Signal SWI und aktualisiert damit die Signalerzeugung für das jeweilige Kraftmessmodul 210. Das neue Tastverhältnis wird dann wieder bis zum Ende des neuen Zeitintervalls, also bis zur nächsten Aktualisierung beibehalten.

Der PWM-Generator GEN kann beispielsweise in Form eines Mikroprozessors ausgebildet sein, bei dem Informationen zur Erzeugung der jeweiligen synchronisierten, puls-weiten-modulierten Signale SWI durch Registereinträge gespeichert werden.

Durch diese zentrale, gemeinsam genutzte Synchronisation kann auf individuelle Synchronisationsvorrichtungen 234 in den einzelnen Kraftmessmodulen 210 verzichtet und somit eine kostengünstiger Aufbau der Mehrfach-Kraftmesssvorrichtung 200 erreicht werden.

Die Baugruppen der Synchronisationsvorrichtung 234, des Analog-Digital-Wandler A/D und des PWM-Generator GEN sind in dieser Ausführungsform in einer Kontrolleinheit CONT zusammengefasst. Es kann aber auch die Multiplexvorrichtung MUX und/oder der Taktgenerator FG und/oder der Ramp-Reset Generator RR in der Kontrolleinheit CONT integriert sein. Vorzugsweise wird die Kontrolleinheit CONT durch einen handelsüblichen Miroprozessor oder durch spezialisierte Baugruppen implementiert.

Wie in den zuvor beschriebenen Ausführungsbeispielen lässt sich auch in diesem Fall das Prinzip in analoger Weise auf eine Mehrfach-Kraftmesssvorrichtung 200 mit einer beliebigen Anzahl von Kraftmessmodulen 210 fortsetzen. Sowohl die Multiplexvorrichtung MUX als auch der PWM-Generator GEN können grundsätzlich eine beliebige Anzahl von Kanälen verarbeiten ohne dass die Ausführungsform der Mehrfach-Kraftmesssvorrichtung 200 wesentlich geändert werden müsste.

Durch die zentrale Erzeugung des Reset-Signals für die Rampengeneratoren RG und des synchronisierten, puls-weiten-modulierten Signals für die Modulationsvorrichtung 230 kann die Anzahl der Bauelemente und die entsprechende Wärmeentwicklung bei der Mehrfach-Kraftmesssvorrichtung 200, insbesondere bei einer Vielzahl von Kraftmessmodulen 210, stark reduziert werden.

### Bezugszeichenliste

- 2: feststehender Bereich
- 3: vertikal auslenkbarer Bereich
- 4: Lenker
- 5, 7: Biegelager
- 6: Hebel
- 8, 12: Hebelarm
- 9: Koppelelement
- 10: Permanentmagnetsystem
- 11: Luftspalt
- 13: Spule
- 14: opto-elektrischer Positionsgeber
- 15: Ausleger
- 16: Regeleinrichtung
- 200: Mehrfach-Kraftmessvorrichtung
- 202: Grundplatte
- 210: Kraftmessmodul
- 212: Kraftübertragungsgestänge
- 214: Kraftaufnehmer
- 216: Durchführung
- 220: Kraftmesszelle
- 230: Modulationsvorrichtung
- 232: Trägersignalquelle
- 234: Synchronisationsvorrichtung
- 240: Signalleitung
- 270: Auswerteeinheit
- 274: Signalverarbeitung
- V_{Ref0}: Referenzspannung der Auswerteeinheit
- V_{Ref1}, V_{Ref1}, ... V_{Refn}: Modulreferenzspannung
- S_{M1}, S_{M2}, ... S_{Mn}: Messsignal
- S_{TX1}, S_{TX2}, ... S_{TXn}: Sendesignal
- S_{C1}, S_{C2}, ... S_{Cn}: Trägersignal
- S_{CL}: Taktsignal
- S_{RR}: Ramp-Reset Signal
- S_{D}: digitales Signal
- MUX: Multiplexvorrichtung
- DMOD: Demodulationsvorrichtung
- A/D: Analog-Digital-Wandler
- PWM: Puls-Weiten-Modulation
- SWI: synchronisiertes, puls-weiten-moduliertes Signal
- INT: Integrator
- OA: Operationsverstärker
- C: Kondensator
- Rin: Eingangswiderstand
- R0: Referenzwiderstand
- SW: Schaltvorrichtung
- CMP: Komparator
- RG: Rampengenerator
- T0: Periodendauer/Arbeitsperiode
- Vc: Ausgangsspannung V_{C} des Integrators
- V_{R}: Ausgangsspannung V_{C} des Rampengenerators
- SWI: Ausgangssignals der Kippstufe
- CNT: Ausgangssignal des Gatters
- T0: Periodendauer
- T1, T2: Periodenanteil
- FF: Kippstufe
- DIV: Teilungsstufe
- FG: Taktgenerator
- G: Gatter
- CTR: Zähler
- CONT: Kontrolleinheit
- S1, S2: Schaltgruppe
- S1 a, S1 b, S2a, S2b: Schaltelement
- RR: Ramp-Reset Generator

- GEN: PWM-Generator

## Patentansprüche

1. Verfahren zur Messwerterfassung in einer Mehrfach-Kraftmessvorrichtung (200), insbesondere einer Mehrfach-Wägevorrichtung, mit mindestens zwei, jeweils eine Kraftmesszelle (220) aufweisenden Kraftmessmodulen (210) und mit einer Auswerteeinheit (270), mit der die von den Kraftmesszellen (220) erzeugten Messsignale (S_{M1}, S_{M2}, ... S_{Mn}) ausgewertet werden, **dadurch gekennzeichnet, dass** in den Kraftmessmodulen (210) das Messsignal (S_{M1}, S_{M2}, ... S_{Mn}) jeweils zu einem pulsförmigen Sendesignal (S_{TX1}, S_{TX2}, ... S_{TXn}) moduliert wird und dass dieses Sendesignal (S_{TX1}, S_{TX2}, ... S_{TXn}) über mindestens eine Signalleitung (240) an die Auswerteeinheit (270) übertragen wird.

2. Verfahren zur Messwerterfassung nach Anspruch 1, **dadurch gekennzeichnet, dass** die Kraftmesszellen (220) jeweils ein analoges Messsignal (S_{M1}, S_{M2}, ... S_{Mn}) erzeugen und/oder dass das Sendesignal (S_{TX1}, S_{TX2}, ... S_{TXn}) jeweils als puls-weiten-moduliertes Signal (PWM) oder als zeitdiskretes, puls-weiten-moduliertes Signal (SWI) oder als Signal in Form von Zählpulsen erzeugt wird.

3. Verfahren zur Messwerterfassung nach Anspruch 1 oder 2, **dadurch gekennzeichnet, dass** das Sendesignal (S_{TX1}, S_{TX2}, ... S_{TXn}) bezüglich eines, gegebenenfalls durch die Auswerteeinheit (270) erzeugten, Taktsignals (S_{CL}) oder Ramp-Reset Signals (S_{RR}) synchronisiert wird.

4. Verfahren zur Messwerterfassung nach einem der Ansprüche 1 bis 3, **dadurch gekennzeichnet, dass** das Messsignal (S_{M1}, S_{M2}, ... S_{Mn}) gemäss dem Prinzip des "integrierenden Charge Balancing" Verfahrens zu einem pulsförmigen Sendesignal (S_{TX1}, S_{TX2}, ... S_{TXn}) moduliert wird.

5. Verfahren zur Messwerterfassung nach einem der Ansprüche 1 bis 4, **dadurch gekennzeichnet, dass** das Messsignal (S_{M1}, S_{M2}, ... S_{Mn}) bezüglich einer am Kraftmessmodul (210) anliegenden, gegebenenfalls durch die Auswerteeinheit (270) erzeugten, Modulreferenzspannung (V_{Ref1}, V_{Ref2}, ... V_{Refn}) moduliert wird.

6. Verfahren zur Messwerterfassung nach einem der Ansprüche 1 bis 5, **dadurch gekennzeichnet, dass** die Sendesignale (S_{TX1}, S_{TX2}, ... S_{TXn}) der mindestens zwei Kraftmessmodule (210) durch eine in der Auswerteeinheit (270) angeordnete Schaltvorrichtung, insbesondere durch einen Multiplexer (MUX), selektiv zur weiteren Verarbeitung durchgeschaltet wird.

7. Verfahren zur Messwerterfassung nach einem der Ansprüche 1 bis 6, **dadurch gekennzeichnet, dass** das Sendesignal (S_{TX1}, S_{TX2}, ... S_{TXn}) in der Auswerteeinheit (270) durch eine Kontrolleinheit (CONT) verarbeitet, insbesondere durch eine Demodulationsvorrichtung (DMOD) demoduliert und/oder durch eine Synchronisationsvorrichtung (234) synchronisiert und/oder durch eine Zählvorrichtung (274) dessen Zählimpulse erfasst und/oder durch einen Analog-Digital-Wandler (A/D) gewandelt wird.

8. Verfahren zur Messwerterfassung nach einem der Ansprüche 1 bis 7, **dadurch gekennzeichnet, dass** durch einen in der Auswerteeinheit (270) angeordneten PWM-Generator (GEN) mindestens ein puls-weiten-moduliertes Signal (PWM) oder ein zeitdiskretes, puls-weiten-moduliertes Signal (SWI) erzeugt und dieses an die mindestens zwei Kraftmessmodule (210) weitergeleitet wird.

9. Mehrfach-Kraftmessvorrichtung (200), insbesondere Mehrfach-Wägevorrichtung, mit mindestens zwei, jeweils eine Kraftmesszelle (220) aufweisenden Kraftmessmodulen (210) und mit einer Auswerteeinheit (270) mit welcher die von den Kraftmesszellen (220) erzeugten Messsignale (S_{M1}, S_{M2}, ... S_{Mn}) auswertbar sind, **dadurch gekennzeichnet, dass** die Kraftmessmodule (210) jeweils eine Modulationsvorrichtung (230) aufweisen, welche mit der Kraftmesszelle (220) und mit mindestens einer Signalleitung (240) verbunden ist und mit welcher ein pulsförmiges, über die Signalleitung (240) an die Auswerteeinheit (270) übertragbares Sendesignal (S_{TX1}, S_{TX2}, ... S_{TXn}) erzeugbar ist.

10. Mehrfach-Kraftmessvorrichtung (200) nach Anspruch 9, **dadurch gekennzeichnet, dass** das Messsignal (S_{M1}, S_{M2}, ... S_{Mn}) als analoges Signal und/oder dass das Sendesignal (S_{TX1}, S_{TX2}, ... S_{TXn}) als puls-weiten-moduliertes Signal (PWM) oder als zeitdiskretes, puls-weiten-moduliertes Signal (SWI) oder als Signal in Form von Zählpulsen ausgebildet ist.

11. Mehrfach-Kraftmessvorrichtung (200) nach Anspruch 9 oder 10, **dadurch gekennzeichnet, dass** die Modulationsvorrichtung (230) oder die Auswerteeinheit (270) eine Synchronisationsvorrichtung (234) aufweist, mit der das Sendesignal (S_{TX1}, S_{TX2}, ... S_{TXn}) bezüglich eines, gegebenenfalls durch die Auswerteeinheit (270) erzeugten, Taktsignals (S_{CL}) oder Ramp-Reset Signals (S_{RR}) synchronisierbar ist.

12. Mehrfach-Kraftmessvorrichtung (200) nach einem der Ansprüche 9 bis 11, **dadurch gekennzeichnet, dass** die Auswerteeinheit (270) eine Schaltvorrichtung (272), insbesondere einen Multiplexer (MUX), aufweist, mit der die Sendesignale (S_{TX1}, S_{TX2}, ... S_{TXn}) der mindestens zwei Kraftmessmodule (210) selektiv zur weiteren Verarbeitung durchschaltbar sind.

13. Mehrfach-Kraftmessvorrichtung (200) nach einem der Ansprüche 9 bis 12, **dadurch gekennzeichnet, dass** die Modulationsvorrichtungen (230) der mindestens zwei Kraftmessmodule (210) jeweils über eine gemeinsame Signalleitung (240) mit der Auswerteeinheit (270) verbunden sind, über welche die Sendesignale (S_{TX1}, S_{TX2}, ... S_{TXn}), gegebenenfalls gesteuert durch eine Kontrolleinheit (CONT), an die Auswerteeinheit (270) übertragen werden.

14. Mehrfach-Kraftmessvorrichtung (200) nach einem der Ansprüche 9 bis 13, **dadurch gekennzeichnet, dass** die Auswerteeinheit (270) weitgehend isoliert und/oder weitgehend räumlich getrennt und/oder weitgehend thermisch isoliert von den Kraftmesszellen (220) angeordnet ist.

15. Mehrfach-Kraftmessvorrichtung (200) nach einem der Ansprüche 9 bis 14, **dadurch gekennzeichnet, dass** die Auswerteeinheit (270) eine Spannungsquelle zur Erzeugung einer vorzugsweise gegen Temperatureinflüsse und/oder Schwankungen der Stromversorgung stabilisierten Referenzspannung (V_{Ref0}) aufweist, welche den einzelnen Kraftmessmodulen (210) zuführbar ist.

16. Mehrfach-Kraftmessvorrichtung (200) nach Anspruch 15, **dadurch gekennzeichnet, dass** die Modulreferenzspannung (V_{Ref1}, V_{Ref1}, ... V_{Refn}) als weitgehend konstante Modulreferenzspannung gemäss der Beziehung V_{Ref1} = V_{Ref2}= ... = V_{Refn} anliegt.

17. Mehrfach-Kraftmessvorrichtung (200) nach einem der Ansprüche 9 bis 16, **dadurch gekennzeichnet, dass** mindestens ein Kraftmessmodul (210) abschaltbar und/oder auswechselbar ist, während mindestens ein weiteres Kraftmessmodul (210) den kontinuierlichen Messbetrieb fortsetzt.

18. Mehrfach-Kraftmessvorrichtung (200) nach einem der Ansprüche 9 bis 17, **dadurch gekennzeichnet, dass** die Auswerteeinheit (270) einen mit den mindestens zwei Kraftmessmodulen (210) verbundenen Taktgenerator (FG) zur Erzeugung eines Taktsignals S_{CL} und/oder einen mit den mindestens zwei Kraftmessmodulen (210) verbundenen Ramp-Reset Generator (RR) zur Erzeugung eines Ramp-Reset Signals S_{RR} aufweist.

19. Mehrfach-Kraftmessvorrichtung (200) nach einem der Ansprüche 9 bis 18, **dadurch gekennzeichnet, dass** die Auswerteeinheit (270) einen Signalgenerator (GEN) aufweist, welcher mit den Modulationsvorrichtungen (230) der mindestens zwei Kraftmessmodule (210) verbunden ist und welcher für jedes Kraftmessmodul (210) ein puls-weiten-moduliertes (PWM) oder ein synchronisiertes puls-weiten-moduliertes (SWI) Signal erzeugt.

20. Kraftmessmodul (210) für eine Mehrfach-Kraftmessvorrichtung (200) gemäss einem der Ansprüche 9 bis 19, **dadurch gekennzeichnet, dass** das Kraftmessmodul (210) eine mit der Modulationsvorrichtung (230) und der Signalleitung (240) verbundene Schaltvorrichtung (MX1, MX2) aufweist, mit welcher das Sendesignal (S_{TX1}, S_{TX2}, ... S_{TXn}) zwischen einer Übertragung zur Signalleitung (240) oder einer Rückkopplung in der Modulationsvorrichtung (230) umschaltbar ist.
